# EUROPEAN PATENT SPECIFICATION

(11) **EP 3 176 810 B1**
(45) Date of publication and mention of the grant of the patent: **04.12.2019**
(21) Application number: 15826876.3
(22) Date of filing: 18.06.2015
(51) Int. Cl.: C09G 1/02, H01L 21/306, H01L 21/02

(54) **METHOD FOR POLISHING GERMANIUM WAFER**
VERFAHREN ZUM POLIEREN VON GERMANIUMWAFERN
PROCÉDÉ DE POLISSAGE D'UNE TRANCHE DE GERMANIUM

(30) Priority: 28.07.2014 JP 2014152784
(43) Date of publication of application: 07.06.2017
(73) Proprietor: Shin-Etsu Handotai Co., Ltd., Tokyo 100-0004 (JP)
(72) Inventor: NAGAOKA, Yasuo, Annaka-shi Gunma 379-0196 (JP); AGA, Hiroji, Annaka-shi Gunma 379-0196 (JP)
(74) Representative: Wibbelmann, Jobst
(86) International application number: PCT/JP2015/003046
(87) International publication number: WO 2016/017063

(56) References cited:
- WO-A1-2013/157442
- WO-A2-2013/018015
- CN-A- 101 611 116
- JP-A- H10 270 401
- JP-A- 2008 529 280
- JP-A- 2013 533 614
- US-A1- 2003 178 320
- US-A1- 2007 293 048
- US-A1- 2008 265 375
- US-A1- 2010 012 976
- US-B1- 6 524 167

## Description

### TECHNICAL FIELD

The present invention relates to a method for polishing a germanium wafer.

### BACKGROUND ART

Germanium (Ge) single crystals has high mobility of electrons and positive holes compared to silicon (Si) single crystals. Accordingly, GeOI (Germanium On Insulator) is considered to be useful as a substrate for a next-generation CMOS (Complementary Metal Oxide Semiconductor). Previously, it has been proposed many methods as a method for producing GeOI.

The first publicly known method for producing GeOI is a method of using an ion implantation delamination method, and using transference of a layer from a donor wafer composed of a germanium single crystal (see Patent Document 1). The oxidized surface of a handle wafer (a support substrate) composed of a silicon single crystal is bonded to the donor wafer. The donor wafer and the handle wafer are then separated (delaminated) along the cleaved surface so as to retain a thin layer of Ge on the silicon oxide. The surface roughness of the transferred Ge layer, however, has to be processed by CMP (chemical mechanical polishing). Accordingly, it is difficult to form a Ge layer with good film thickness uniformity.

The second publicly known method includes epitaxial growth of an SiGe graded layer on a silicon donor wafer and epitaxial growth of a Ge layer on the SiGe graded layer (see Patent Document 2). Then, the Ge layer or the SiGe/Ge layer is transferred onto a handle wafer by an ion implantation delamination method. The Ge layer grown on the SiGe graded layer, however, has a threading dislocation density of about 10⁶ to 10⁸ cm⁻², which causes to lower the performance of a device. Since the Ge layer is exposed from the transferred SiGe/Ge layer, it is difficult to selectively etch only the transferred layer of the SiGe graded layer having high Ge content.

Both of these two methods need a step of bonding the Ge surface and the support substrate. Accordingly, the Ge surface have to be previously polished to make the surface roughness be so flat as not to generate an interface defect such as a void or a blister when it is bonded with the support substrate and the Ge thin film is delaminated. In case of the first method, the Ge surface have to be processed by CMP (chemical mechanical polishing) even after the Ge thin film is delaminated.

As a method for polishing a Ge single crystalline substrate, it has been known a method described in Non Patent Document 1, for example. Non-Patent Document 1 has concluded that slurry which contains colloidal silica and sodium hypochlorite as an oxidizing agent or a polishing accelerator is good as a polishing agent (slurry) for a Ge substrate to give a good polished surface (p. 106 of Non-Patent Document 1).

### CITATION LIST

### PATENT LITERATURE

Patent Document 1: Japanese Unexamined Patent publication (Kokai) No. H5-211128
Patent Document 2: Japanese Unexamined Patent publication (Kokai) No. 2008-141206
Patent Document 3: Japanese Unexamined Patent publication (Kokai) No. 2007-5562

### NON PATENT LITERATURE

Non Patent Document 1: Isamu Koshiyama et. al., "A study on the effect of oxidants in chemical mechanical polishing of germanium mono-crystalline wafers", Journal of the Japan Society for Abrasive Technology, Vol.50, No.2, p. 102-106 (2006, February).

Further, document US2010/012976 A1 discloses addition of hydrogen peroxide to an aqueous solution containing colloidal silica in order to polish a Ge-SiO₂ composite structure.

### SUMMARY OF INVENTION

### TECHNICAL PROBLEM

The acidic slurry using sodium hypochlorite as an oxidizing agent, however, is feared to rust a polishing apparatus since it is not acid resistance. In addition, it is not practical since the rustproof measure needs huge conversion cost.

Non Patent Document 1 also describes polishing by use of hydrogen peroxide as an oxidizing agent. However, it only discloses values of 1, 5, and 20 vol% as an added amount of hydrogen peroxide (FIG. 7 in Non Patent Document 1). The use of hydrogen peroxide as an oxidizing agent is described negatively such that an addition of 5 vol% or more slightly changes the polishing efficiency and has little effect on acceleration of polishing. This reason is assumed that the intention was efficient flattening by elevating the polishing rate since the polishing target is a Ge single crystalline substrate, which does not have a substantial limitation on the polishing stock removal.

However, when hydrogen peroxide is added in these concentrations to polish a Ge surface in practice, interface defects such as voids and blisters generate frequently in the use of it as a wafer to be bonded, since the polished surface cannot have sufficiently small surface roughness.

On the other hand, Patent Document 3 describes polishing of a germanium wafer by using alkaline slurry which contains colloidal silica, hydrogen peroxide, and organic phosphonic acid. In the example, however, the surface roughness (Ra) after polishing is 0.385 nm at minimal. Accordingly, when a Ge thin film is formed by bonding and delaminating a Ge surface with such a surface roughness, it is not possible to sufficiently suppress generation of interface defects such as voids and blisters as Non Patent Document 1.

As described above, when a Ge surface is polished by previous polishing method, it is not possible to have the surface roughness sufficiently small. Accordingly, when it is used for a wafer to be bonded, generation of interface defects such as voids and blisters cannot be suppressed sufficiently.

The present invention was accomplished in view of the above-described problems. It is an object of the present invention to provide a method for polishing a germanium wafer that can make the surface roughness of a Ge surface after polishing be sufficiently small, and can sufficiently suppress generation of interface defects such as voids and blisters thereby when it is used for a wafer to be bonded.

### SOLUTION TO PROBLEM

To achieve the foregoing object, the present invention provides a method for polishing a germanium wafer having a surface composed of germanium, comprising: adding aqueous hydrogen peroxide to a first polishing slurry of an aqueous alkaline solution containing colloidal silica to make a second polishing slurry, and polishing the surface of the germanium wafer by using the second polishing slurry; wherein the aqueous hydrogen peroxide is added to the first polishing slurry in a concentration such that 30 wt% aqueous hydrogen peroxide is added in a volume of more than 0.005 vol% and 0.05 vol% or less based on the volume of the first polishing slurry, and the surface of the germanium wafer is polished by using the second polishing slurry.

A polishing slurry of an aqueous alkaline solution containing colloidal silica (the first polishing slurry in the present invention) has been generally used for polishing of silicon single crystal wafers, and its mass production technology have been established. When this slurry is used for polishing a Ge surface, the polishing will never proceed without addition of hydrogen peroxide. However, the polishing proceeds and the polishing can securely give a Ge surface with small surface roughness by polishing the Ge surface using the second polishing slurry in which small quantity of hydrogen peroxide is added, that is, hydrogen peroxide is added to the foregoing slurry in a concentration such that 30 wt% aqueous hydrogen peroxide is added in a volume of more than 0.005 vol% and 0.05 vol% or less. A Ge surface can be polished only by adding small quantity of hydrogen peroxide with the foregoing concentration to a polishing slurry that is generally used for polishing a silicon single crystalline wafer. Accordingly, it has an advantage that a polishing apparatus for a silicon single crystalline wafer, which possesses established mass production technology, can be used intact. For example, it is possible to cope with polishing of a Ge surface in a large-diameter wafer with a diameter of 300 mm. The lower limit of a volume of aqueous hydrogen peroxide to be added is preferably 0.001 vol% or more, and more preferably 0.003 vol% or more.

According to the present invention, the aqueous hydrogen peroxide is added in a concentration such that 30 wt% aqueous hydrogen peroxide is added in a volume of 0.005 vol% or more and 0.05 vol% or less based on the volume of the first polishing slurry.

It is possible to decrease the surface roughness more effectively especially by using polishing slurry in which the aqueous hydrogen peroxide is added in a concentration such that 30 wt% aqueous hydrogen peroxide is added in a volume of 0.005 vol% or more and 0.05 vol% or less.

In this case, the germanium wafer can be a silicon single crystalline wafer having an epitaxial layer composed of germanium formed on an outmost surface thereof.

The inventive polishing method can be preferably used for polishing of such a germanium wafer having an epitaxial layer composed of germanium.

In this case, the epitaxial layer composed of germanium can have a thickness of 1 µm or less.

The inventive polishing method can be preferably performed even when the thickness of a germanium layer is thin such as 1 µm or less, and accordingly the polishing stock removal is limited.

In this case, the surface of the germanium wafer to be polished can have surface roughness (RMS) of 0.20 nm or less.

As described above, the present invention can perform polishing even on a surface of a germanium wafer with fairly good surface roughness to further reduce the surface roughness.

### ADVANTAGEOUS EFFECTS OF INVENTION

The inventive method for polishing a germanium wafer can sufficiently reduce the surface roughness of a polished Ge surface, and can give a germanium wafer that can sufficiently suppress generation of interface defects such as voids and blisters particularly when the germanium wafer is used as a wafer to be bonded.

### BRIEF DESCRIPTION OF DRAWINGS

FIG. 1 is a flow diagram to show an example of the inventive method for polishing a germanium wafer;
FIG. 2 is a schematic diagram to show an example of a polishing apparatus which can be used for the inventive method for polishing a germanium wafer;
FIG. 3 is a diagram to show surface roughness (RMS) of surfaces of polished germanium wafers measured in Examples 1 and 2 as well as Comparative Examples 1 and 2.

### DESCRIPTION OF EMBODIMENTS

Hereinafter, the embodiments of the present invention will be described, but the present invention is not limited thereto.

As described above, when a Ge surface is polished by previous polishing method, it is not possible to have the surface roughness sufficiently small. Therefore, particularly when it is used for a wafer to be bonded, generation of interface defects such as voids and blisters cannot be suppressed sufficiently.

Accordingly, the present inventors have specifically investigated to solve such problems, and consequently have conceived that a germanium wafer with good surface roughness can be obtained by adding hydrogen peroxide to a previous polishing slurry for polishing a silicon single crystalline wafer in a concentration such that 30 wt% aqueous hydrogen peroxide is added in a volume of more than 0.005 vol% and 0.05 vol% or less based on the volume of the polishing slurry, and by using thereof; thereby completing the present invention.

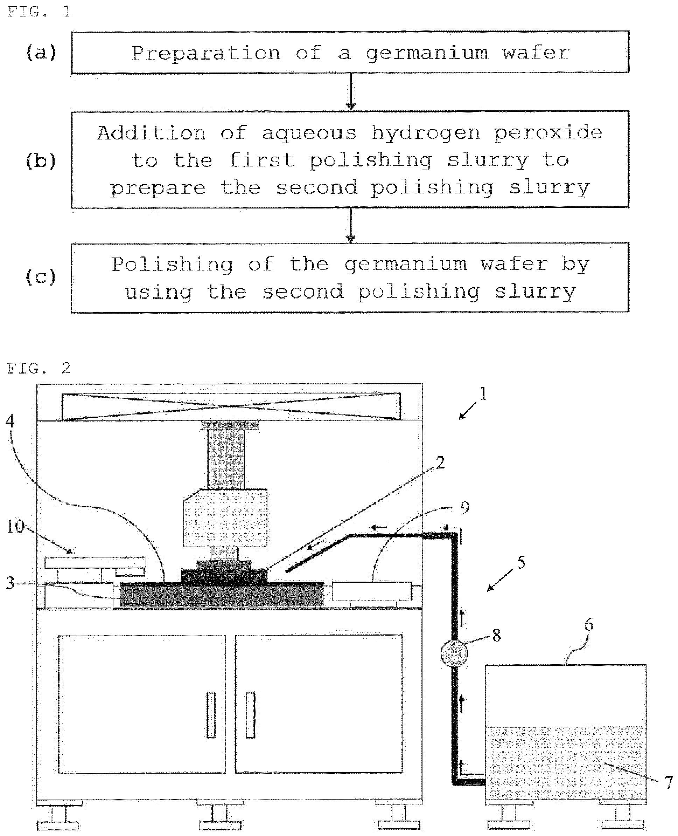

Hereinafter, the present invention will be described specifically. Herein, an example of the inventive method for polishing a germanium wafer will be described along the flow diagram shown in FIG. 1.

As shown in FIG. 1 (a), first, a germanium wafer to be polished is prepared. Herein, the germanium wafer in the present invention means a wafer at least the surface thereof to be polished is composed of germanium. This means that the object to be polished can be a germanium single crystalline substrate that is entirely composed of a germanium single crystal, and can be a silicon single crystalline wafer having an epitaxial layer composed of germanium formed on an outmost surface thereof or a GeOI wafer in which a germanium layer is formed on a support substrate such as a silicon single crystalline wafer via an insulator film, for example.

It is possible to obtain the wafer having an epitaxial layer composed of germanium formed on an outmost surface thereof by epitaxial growth of a germanium layer on a silicon single crystalline wafer or an SOI wafer after forming a buffer layer to relax a lattice constant of a SiGe layer and so on, for example. The present invention is particularly suitable for polishing a surface of such an epitaxial layer composed of germanium.

In this case, the thickness of the epitaxial layer composed of germanium can be 1 µm or less. The present invention can be preferably performed even when the polishing stock removal is limited with the thickness of a germanium layer being thin such as 1 µm or less.

The germanium wafer to be polished can also be the one with the surface having surface roughness (RMS) of 0.20 nm or less.

When a Ge layer is produced by epitaxial growth, the epitaxial growth is generally performed on a substrate with a mirror polished surface. Accordingly, the surface of the Ge epitaxial layer originally (at a stage prior to the polishing) has fairly good surface roughness (RMS≤0.20 nm). When such a germanium wafer having a grown Ge layer is used as a wafer to be bonded, it is preferable that the surface roughness be once made smaller by slightly polishing the surface of the Ge layer in order to decrease generation of interface defects such as voids and blisters as possible. In this case, the present invention can reduce the surface roughness smaller by polishing.

Then, as shown in FIG. 1 (b), the second slurry used in polishing of a germanium wafer is prepared. In the inventive polishing method, aqueous hydrogen peroxide is added to a first polishing slurry of an aqueous alkaline solution containing colloidal silica to make a second polishing slurry, and the germanium wafer is polished by using the second polishing slurry. As the first polishing slurry, it is possible to use the one that have been previously used for polishing a silicon single crystalline substrate. The aqueous hydrogen peroxide is added in a concentration such that aqueous hydrogen peroxide with a concentration of 30 wt% is added in a volume of more than 0 vol% and 0.1 vol% or less based on the volume of the first polishing slurry. By using the second polishing slurry in which aqueous hydrogen peroxide is added in such a concentration for polishing, the surface roughness of the surface of a germanium wafer can be smaller by polishing.

The aqueous hydrogen peroxide is added in a concentration such that aqueous hydrogen peroxide with a concentration of 30 wt% is added in a volume of 0.005 vol% or more and 0.05 vol% or less based on the volume of the first polishing slurry. By adding aqueous hydrogen peroxide in such a concentration, it is possible to prepare polishing slurry that can make surface roughness further smaller. The second polishing slurry used for polishing a germanium wafer is produced as described above.

Subsequently, as shown in FIG. 1 (c), a germanium wafer is polished by using the second polishing slurry prepared in FIG. 1 (b).

Herein, a polishing apparatus which can be used for polishing of a germanium wafer will be described with referring to FIG. 2.

As shown in FIG. 2, the polishing apparatus 1 can be a single-side polishing apparatus mainly composed of a table 3 attached with a polishing pad 4, a polishing slurry supply mechanism 5, a polishing head 2, etc. It is also possible to be provided with a stage 9 to perform loading of a germanium wafer to the polishing head 2, unloading from the polishing head 2, and washing of the polishing head 2; a brush 10 for dressing the polishing pad 4; etc. as shown in FIG. 2. The polishing head 2 can be made of ceramic, for example. The material of the polishing pad 4 can be a suede material, for example.

In such a polishing apparatus 1, the surface of a germanium wafer is polished by holding a germanium wafer to be polished by the polishing head 2, moving the germanium wafer and the table 3 relatively, with the surface of the germanium wafer being pressed against the polishing pad 4, while supplying the second polishing slurry 7 onto the polishing pad 4 from the polishing slurry supply mechanism 5.

It is preferred that the second polishing slurry 7 be continuously supplied during the polishing of a germanium wafer by the polishing slurry supply mechanism 5 provided with a tank 6 to store the second polishing slurry 7, a pump 8 to send the second polishing slurry 7 in the tank 6 onto the polishing pad 4, etc. so as to continually cover the surface of the polishing pad 4 with the second polishing slurry.

As described above, the inventive polishing method can make the surface roughness of a polished Ge surface sufficiently small by polishing the surface of the germanium wafer with the second polishing slurry in which aqueous hydrogen peroxide is added in the foregoing concentration, and can particularly give a germanium wafer that can sufficiently suppress generation of interface defects such as voids and blisters thereby when it is used for a wafer to be bonded. It also can polish a Ge surface only by adding small quantity of hydrogen peroxide with the foregoing concentration to the first polishing slurry, which is generally used for polishing a silicon single crystalline wafer. Accordingly, it has an advantage that a polishing apparatus for a silicon single crystalline wafer, which possesses established mass production technology, (for example, the polishing apparatus 1 shown in FIG. 2) can be used intact without a particular rustproof measure. For example, it is possible to cope with polishing of a Ge surface in a large-diameter wafer with a diameter of 300 mm.

### EXAMPLES

Hereinafter, the present invention will be more specifically described with reference to Examples and Comparative Examples, but the present invention is not limited thereto.

### (Example 1)

In accordance with the flow diagram shown in FIG. 1, polishing of a germanium wafer was performed. First, the following wafers were prepared as the germanium wafer.

### (Germanium wafer)

As the germanium wafer, a germanium wafer having an epitaxial-grown Ge single crystalline layer on the outmost surface via a buffer layer was prepared. The Ge single layer has a thickness of 500nm and the silicon single crystalline wafer has a diameter of 200 mm. The Ge single crystalline layer of this germanium wafer had a surface roughness of 0.147 nm in terms of RMS and 0.112 nm in terms of Ra.

The second polishing slurry used for polishing the foregoing germanium wafer was prepared as follows.

### (The first polishing slurry)

As the first polishing slurry to which aqueous hydrogen peroxide is added, G3900RS (which contains colloidal silica, manufactured by Fujimi Incorporated) diluted 20-fold with pure water (23°C, pH: 9) was used.

### (Aqueous hydrogen peroxide)

As the aqueous hydrogen peroxide to be added to the first polishing slurry, the one with a concentration of 30 wt% (% by mass) was used.

### (The second polishing slurry)

Four kinds of slurry were prepared by adding 30 wt% aqueous hydrogen peroxide to the first polishing slurry in concentrations of 0.005 vol%, 0.015 vol%, 0.050 vol%, and 0.100 vol% respectively, and used for polishing.

The polishing of the germanium wafer was performed by using the prepared second polishing slurry in the polishing apparatus 1 shown in FIG. 2. In this case, the polishing load was set to 100 gf/cm². The amount of the slurry supplied onto the polishing pad was set to 200 cc/min.

The surface roughness of the polished surface of the germanium wafer was measured with an AFM (atomic force microscope) in a measurement area of 30 µm × 30 µm.

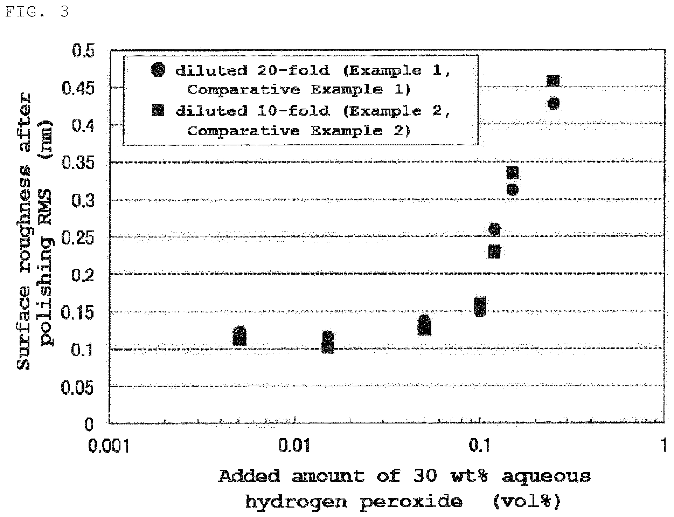

The surface roughness in terms of RMS (nm) and in terms of Ra (nm) measured in Example 1 and the Comparative Example 1, which will be described below, are shown in Table 1 and FIG. 3.

As is revealed from Table 1 and FIG. 3, it was confirmed that the surface roughness of germanium wafers were equivalent or smaller and better values than before polishing. As described above, it has been confirmed that by using polishing slurry in which aqueous hydrogen peroxide is added in a concentration such that 30 wt% aqueous hydrogen peroxide is added in a volume of more than 0 vol% and 0.1 vol% or less, polishing can be performed without causing large degradation of the surface roughness, and the surface roughness can be reduced to better values than before the polishing even in polishing of a Ge surface with the surface roughness being small (RMS≤0.20nm) before polishing.

### (Comparative Example 1)

The second polishing slurries were prepared in the same condition as in Example 1 except that the added amount of 30 wt% aqueous hydrogen peroxide to be added to the first polishing slurry was varied to 0 vol% (without addition), 0.120 vol%, 0.150 vol%, and 0.249 vol% based on the volume of the first polishing slurry. Each of them was used for polishing a germanium wafer, and the surface roughness of the polished germanium surface was measured in the same manner as in Example 1.

As is revealed from the results of Table 1 and FIG. 3, it was confirmed that the surface roughness of each germanium wafer was largely degraded compared to the value before polishing when the concentration of the aqueous hydrogen peroxide to be added is larger than 0.100 vol% based on the volume of the first polishing slurry. On the other hand, when aqueous hydrogen peroxide was not added, the polishing of the surface of a germanium wafer was scarcely proceeded.

**[Table 1]**

| | | Added amount of H₂O₂ (vol%) | Polishing amount (nm) | Surface roughness RMS (nm) | Surface roughness Ra (nm) |
|---|---|---|---|---|---|
| Before polishing | - | - | - | 0.147 | 0.112 |
| After polishing | Comparative Example 1 | 0 | 0 | 0.148 | 0.114 |
| | Example 1 | 0.005 | 26.8 | 0.123 | 0.090 |
| | | 0.015 | 81.0 | 0.116 | 0.092 |
| | | 0.050 | 108.8 | 0.137 | 0.106 |
| Polishing time: 3 minutes | | 0.100 | 195.9 | 0.150 | 0.162 |
| | Comparative Example 1 | 0.120 | 228.3 | 0.260 | 0.183 |
| | | 0.150 | 274.3 | 0.312 | 0.247 |
| | | 0.249 | 438.6 | 0.428 | 0.336 |

### (Example 2)

The second polishing slurry was prepared in the same condition as in Example 1 except that G3900RS (which contains colloidal silica, manufactured by Fujimi Incorporated) diluted 10-fold with pure water (23°C, pH: 9) was used as the first polishing slurry. This was used for polishing a germanium wafer, and the surface roughness of a polished germanium wafer was measured in terms of RMS in the same manner as in Example 1. Incidentally, the surface roughness of the germanium wafer before polishing was 0.131 nm in terms of RMS.

The surface roughness in terms of RMS (nm) measured in Example 2 and the Comparative Example 2, which will be described below, are shown in Table 2 and FIG. 3.

As shown in Table 2 and FIG. 3, it was confirmed that the surface roughness of germanium wafers were equivalent or smaller and better values than before polishing. As described above, it has been confirmed that by using polishing slurry in which aqueous hydrogen peroxide is added in a concentration such that 30 wt% aqueous hydrogen peroxide is added in a volume of more than 0 vol% and 0.1 vol% or less, polishing can be performed without causing large degradation of the surface roughness, and the surface roughness can be reduced to better values than before the polishing even in polishing of a Ge surface with the surface roughness being small (RMS≤0.20nm) before polishing.

### (Comparative Example 2)

The second polishing slurries were prepared in the same condition as in Example 2 except that the amount of 30 wt% aqueous hydrogen peroxide to be added to the first polishing slurry was varied to 0 vol% (without addition), 0.120 vol%, 0.150 vol%, and 0.249 vol% based on the volume of the first polishing slurry. Each of them was used for polishing of a germanium wafer, and the surface roughness of the polished germanium surface was measured in the same manner as in Example 2. Incidentally, the surface roughness of the germanium wafer before polishing was 0.131 nm in terms of RMS.

As a result, it was confirmed that the surface roughness of each germanium wafer was largely degraded compared to the value before polishing when the concentration of the aqueous hydrogen peroxide to be added was larger than 0.100 vol% based on the volume of the first polishing slurry as is revealed from Table 2 and FIG. 3. On the other hand, when aqueous hydrogen peroxide was not added, the polishing of the surface of a germanium wafer was scarcely proceeded, and the surface roughness was deteriorated.

**[Table 2]**

| | | Added amount of H₂O₂ (vol%) | Polishing amount (nm) | Surface roughness RMS (nm) |
|---|---|---|---|---|
| Before polishing | - | - | - | 0.131 |
| After polishing P | Comparative Example 2 | 0 | 0 | 0.133 |
| | Example 2 | 0.005 | 20.5 | 0.112 |
| | | 0.015 | 78.0 | 0.101 |
| | | 0.050 | 112.8 | 0.126 |
| olishing time: 3 minutes | | 0.100 | 204.0 | 0.160 |
| | Comparative Example 2 | 0.120 | 238.5 | 0.230 |
| | | 0.150 | 299.9 | 0.335 |
| | | 0.249 | 455.4 | 0.458 |

It is to be noted that the present invention is not limited to the foregoing embodiment. The embodiment is just an exemplification, and any examples that do not depart from the scope of the invention as defined in the appended claims are included in the technical scope of the present invention. In this case, aqueous hydrogen peroxide may be added in a concentration such that 30 wt% aqueous hydrogen peroxide is added in a volume of more than 0.005 vol% and 0.05 vol% or less.

## Claims

1. A method for polishing a germanium wafer used as a wafer to be bonded, and having a surface to be polished composed of germanium, comprising:
adding aqueous hydrogen peroxide to a first polishing slurry of an aqueous alkaline solution containing colloidal silica which is used for polishing a silicon single crystalline wafer to make a second polishing slurry, and polishing the surface of the germanium wafer by using the second polishing slurry; wherein
the aqueous hydrogen peroxide is added to the first polishing slurry in a concentration such that 30 wt% aqueous hydrogen peroxide is added in a volume of 0.005 vol% or more and 0.05 vol% or less based on the volume of the first polishing slurry, and the surface of the germanium wafer is polished by using the second polishing slurry.

2. The method for polishing a germanium wafer according to claim 1, wherein the germanium wafer is a silicon single crystalline wafer having an epitaxial layer composed of germanium formed on an outmost surface thereof.

3. The method for polishing a germanium wafer according to claim 2, wherein the epitaxial layer composed of germanium has a thickness of 1 µm or less.

4. The method for polishing a germanium wafer according to any one of claims 1 to 3, wherein the surface of the germanium wafer to be polished has surface roughness (RMS) of 0.20 nm or less.

## Patentansprüche

1. Verfahren zum Polieren eines Germaniumwafers, der als ein zu bondender Wafer verwendet wird und der eine zu polierende Oberfläche hat, die aus Germanium besteht, umfassend:
Zugabe eines wässrigen Wasserstoffperoxids zu einer ersten Polieraufschlämmung einer wässrigen Alkalilösung, enthaltend kolloidales Silica, das zum Polieren eines Silizium-Einkristallwafers verwendet wird, um eine zweite Polieraufschlämmung zu erhalten, und Polieren der Oberfläche des Germaniumwafers durch Verwendung der zweiten Polieraufschlämmung; wobei
das wässrige Wasserstoffperoxid der ersten Polieraufschlämmung in einer Konzentration zugegeben wird, sodass 30 Gew.-% wässriges Wasserstoffperoxid in einem Volumen von 0,005 Vol.-% oder darüber und 0,05 Vol.-% oder darunter zugegeben wird, bezogen auf das Volumen der ersten Polieraufschlämmung, und die Oberfläche des Germaniumwafers wird unter Verwendung der zweiten Polieraufschlämmung poliert.

2. Verfahren zum Polieren eines Germaniumwafers nach Anspruch 1, wobei der Germaniumwafer ein Silizium-Einkristallwafer ist, mit einer Epitaxialschicht, bestehend aus Germanium, gebildet auf einer äußersten Oberfläche davon.

3. Verfahren zum Polieren eines Germaniumwafers nach Anspruch 2, wobei die Epitaxialschicht, die aus Germanium besteht, eine Dicke von 1 µm oder darunter hat.

4. Verfahren zum Polieren eines Germaniumwafers nach irgendeinem der Ansprüche 1 bis 3, wobei die Oberfläche des zu polierenden Germaniumwafers eine Oberflächenrauheit (RMS) von 0,20 nm oder darunter hat.

## Revendications

1. Procédé de polissage d'une tranche de germanium utilisée en tant que tranche à lier, et ayant une surface à polir composée de germanium, comprenant :
l'ajout de peroxyde d'hydrogène aqueux à une première suspension épaisse de polissage d'une solution aqueuse alcaline contenant de la silice colloïdale qui est utilisée pour polir une tranche de silicium monocristallin afin de produire une seconde suspension épaisse de polissage, et le polissage de la surface de la tranche de germanium à l'aide de la seconde suspension épaisse de polissage ; dans lequel
le peroxyde d'hydrogène aqueux est ajouté à la première suspension épaisse de polissage à une concentration telle que 30 % en poids de peroxyde d'hydrogène aqueux soient ajoutés dans un volume de 0,005 % en volume ou plus et de 0,05 % en volume ou moins par rapport au volume de la première suspension épaisse de polissage, et la surface de la tranche de germanium est polie à l'aide de la seconde suspension épaisse de polissage.

2. Procédé de polissage d'une tranche de germanium selon la revendication 1, dans lequel la tranche de germanium est une tranche de silicium monocristallin ayant une couche épitaxiale composée de germanium formée sur sa surface la plus externe.

3. Procédé de polissage d'une tranche de germanium selon la revendication 2, dans lequel la couche épitaxiale composée de germanium a une épaisseur de 1 µm ou moins.

4. Procédé de polissage d'une tranche de germanium selon l'une quelconque des revendications 1 à 3, dans lequel la surface de la tranche de germanium à polir a une rugosité de surface (RMS) de 0,20 nm ou moins.
